# EUROPÄISCHE PATENTANMELDUNG

(11) **EP 1 254 970 A1**
(43) Veröffentlichungstag der Anmeldung: **06.11.2002**
(21) Anmeldenummer: 02007878.8
(22) Anmeldetag: 09.04.2002
(51) Int. Cl.: C23C 14/54, C23C 14/35

(54) **Magnetronsputterquelle mit mehrteiligem Target**

(30) Priorität: 03.05.2001 CH 8042001
(71) Anmelder: Unaxis Balzers Aktiengesellschaft, 9496 Balzers (LI)
(72) Erfinder: Dubs, Martin, 9477 Trübbach (CH)

(57) **Zusammenfassung**

Die Erfindung betrifft Vorrichtung und Verfahren zu einer Magnettronsputterquelle mit mehrteiligem Target (3, 4) und beweglichem Magnetsystem (5). Durch Variation der Leistungsabgabe der Stromversorgung (6) lassen sich bestimmte Bereiche des mehrteiligen Targets (3, 4) bevorzugt beeinflussen, was es erlaubt, die Stöchiometrie der abgesputterten Targetmaterialien auf dem zu belegenden Substrat (15) einzustellen und die Homogenität des Schichtaufbaus positiv zu beeinflussen.

## Beschreibung

Die vorliegende Erfindung betrifft ein Verfahren zum Betrieb einer Magnetronsputterquelle nach dem Oberbegriff von Anspruch 1 sowie die Vorrichtung dazu gemäss Oberbegriff von Anspruch 6.

Magnetronsputterquellen werden in Vakuumbeschichtungsanlagen zur Beschichtung von Substraten in vielfältiger Weise eingesetzt. Für den Durchschnittsfachmann geläufig, besteht eine solche Magnetronsputterquelle im wesentlichen aus einem abzusputternden Target und einem dahinter angeordneten Magnetsystem, welches das im Betrieb entstehende Plasma in der Nähe der Targetoberfläche in Form eines geschlossenen Plasmaschlauchs konzentriert, zur Intensivierung des Materialabtrags vom Target.

Eine Vielzahl von Ausprägungen und Spezialanpassungen wurden entwickelt, um dem breiten Anwendungsspektrum gerecht zu werden. Einer dieser Teilbereiche ist das sogenannte Cosputtern, bei dem mehrere Targets unterschiedlicher Materialien verwendet werden oder ein Einzeltarget, das nicht aus einem Block eines einzelnen Materials oder einer Materialmischung besteht, sondern aus verschiedenen Elementen in unterschiedlicher Geometrie zusammengesetzt wird (mehrteiliges oder segmentiertes Target). Damit lassen sich beispielsweise Schichtabfolgen aus unterschiedlichen Materialien erzielen, daneben besteht aber auch die Möglichkeit, die Zusammensetzung der aufzubringenden Schicht während des Sputtervorgangs zu beeinflussen.

Bekannt ist, dass sich durch bewegliche Magnetsysteme bei Magnetronsputterquellen generell die Targetausnutzung und die Schichtdickenverteilung beeinflussen lassen.

Im Stand der Technik sind mehrere Magnetronsputterquellen und Cosputterverfahren bekannt.
Offenbart ist beispielsweise die Anordnung mehrerer gleichzeitig betriebener Sputterquellen gegenüber dem Substrat. Durch Rotation desselben wird eine schichtweise Belegung oder eine Legierungsbeschichtung möglich.

US 4,505,798 beschreibt das Grundprinzip eines mehrteiligen Targets für verschiedene Targetgeometrien (rund, lang, zylindrisch). Insbesondere wird auf die Möglichkeit verwiesen, die Legierungsrate der aufzusputternden Schicht über das Flächenverhältnis der Targetsegmente zu bestimmen.

US 5,512,150 zeigt eine Anordnung von konzentrischen Targetringen über jeweils den Targetabschnitten definiert zuzuordnenden Magnetsystemen. Das Substrat, auf das die Schichten aufgebracht werden erscheint für die Targetabschnitte dadurch unter verschiedenen Winkeln.

US 6,143,149 beschreibt eine Sputtervorrichtung mit mehrteiligem Target, bei dem jedes Targetsegment elektrisch vom anderen isoliert wird und individuell mit einer Stromversorgung verbindbar ist. Dieses Target ist mit Abschirmblechen versehen, die ein unerwünschtes Absputtern von Nachbarsegmenten resp. deren Belegung mit Fremdmaterial verhindern soll.

Allen geschilderten Cosputter-Verfahren und -Vorrichtungen mit mehrteiligen Targets ist es ein gemeinsamer Nachteil, dass sie dem unterschiedlichen Absputterverhalten der Materialien ungenügend Rechnung tragen. Bei gleichbleibender Sputterleistung werden bestimmte Bereiche eines mehrteiligen Targets stärker abgetragen als andere. Darunter leiden die Targetstandzeit und die Materialausbeute. Versuche, dies durch Targetprofilierung oder unterschiedliche Targetdicken auszugleichen, erhöhen den Aufwand bei der Targetherstellung. Weiter sind die Anordnungen, welche eine Beeinflussung der Schichtzusammensetzung während des Sputterprozesses erlauben, bisher nur mit grossem technischen Aufwand zu realisieren.

Es ist daher Aufgabe der vorliegenden Erfindung, die Nachteile des Standes der Technik zu beseitigen und durch die Verwendung der erfindungsgemässen Merkmale eine Sputterquelle zu schaffen, die im Aufbau gegenüber vorbekannten Sputterquellen vereinfacht ist, eine erhöhte Wirtschaftlichkeit aufweist und darüberhinaus eine Variation der Legierungszusammensetzung erlaubt. Daneben soll eine hohe Belegungshomogenität des Substrates gewährleistet werden. Auch eine mechanische Kompatibilität zu bekannten Sputtersystemen mit einteiligem, nichtsegmentiertem Target ist möglich.

Erfindungsgemäss wird die Aufgabe gelöst durch die Merkmale von Anspruch 1 sowie 6. Die Unteransprüche beschreiben weitere vorteilhafte Ausgestaltungen.

Der Betrieb einer Magnetronsputterquelle mit einem mehrteiligen Target, einem beweglichen Magnetsystem und mindestens einer Stromversorgung zur Plasmaerzeugung wird dadurch ausgezeichnet, dass die Leistungsabgabe der mindestens einen Stromversorgung im Betrieb variiert wird.

Wird die Variation der Leistungsabgabe mit der Bewegung des Magnetsystems synchronisiert, bevorzugt gesteuert synchronisiert und insbesondere periodisch, so kann das Zusammentreffen von durch das Magnetsystem beeinflussten Abstäubbereichen selektiv mit bestimmten Flächen des mehrteiligen Targets erzielt werden. Dadurch wird erreicht, dass eine bestimmte Leistungsabgabe der Stromversorgung jeweils auf einen bestimmten, bevorzugt denselben Abschnitt des Targetteils trifft.

In einer weiteren bevorzugten Ausführungsform kann die Variation der Leistungsabgabe für eine Stromversorgung vorgegebenwerden. Insbesondere eine Steuerung wie eine Computersteuerung erlaubt eine Regelung nach vorggebbaren Werten.

Darüberhinaus wird in einer weiteren Ausführungsform mindestens ein Sensor am Magnetsystem eingesetzt, der dessen Lage, z. B. bei rotierenden Systemen den aktuellen Positionswinkel zu einem Bezugspunkt, ermittelt und die Synchronisation der Leistungsabgabe der Stromversorgung mit der Position des Magnetsystems erlaubt.
Vorzugsweise wird das erfindungsgemässe Verfahren in Anordnungen mit runden Quellen eingesetzt, wobei das Magnetsystem hinter der Targetanordnung rotiert. Die Targetanordnung ist hierbei mehrteilig, mindestens zweiteilig, aus den vorgesehenen unterschiedlichen Materialien gebildet, insbesondere bei einer runden Targetanordnung segmentiert. Das Substrat ist vor dem Target im üblichen Abstand von einigen cm angeordnet, parallel oder geneigt zum Target, und wird zur Homogenisierung des Schichtauftrages vorzugsweise bewegt, insbesondere rotiert. Für den Fachmann sind durch Ausnutzen der erfindungsgemässen Leistungsvariation entsprechende Massnahmen möglich, um weitere Effekte zu erzielen. So können Schichteigenschaften, die von der Belegungsrate pro Zeit abhängen (z. B. Mehrfachschichten) beeinflusst werden. Graduelle Änderungen der Zusammensetzung können durch Verändern der Leistungsverhältnisse beim Absputtern unterschiedlicher Targetteile über den Beschichtungszeitraum erzielt werden.

Eine erfindungsgemässe Magnetronsputterquelle zur Beschichtung von Substraten weist ein mehrteiliges Target, ein bewegliches Magnetsystem mit Antrieb zur Beeinflussung der Abstäubbereiche auf dem Target und mindestens eine Stromversorgung auf, sowie Mittel zur Modulierung der Leistungsabgabe und weitere Mittel zur Synchronisierung mit dem Antrieb des Magnetsystems.

Diese Mittel zur Modulierung der Leistungsabgabe können durch Schalter realisiert werden, die ein Einstellen, Modulieren oder Schalten verschiedener Leistungspegel einer oder verschiedener Stromversorgungen erlauben. Weiterhin kann durch eine Steuerungselektronik ein dynamischer Kurvenverlauf oder ein Pulsieren der Ausgangsleistung einer Stromversorgung realisiert werden. Ausführungsformen als separate Steuerungsschaltung zu einer DC- oder RF-Stromversorgung bzw. als programmierbare Stromversorgung sind für den Fachmann unter anderen Möglichkeiten geläufig.

In einer besonderen Ausführungsform ist das mehrteilige Target kreisförmig aufgebaut. Diese Ausführungsform ist für viele Anwendungen in der Halbleiterindustrie (Wafer) oder der Produktion von Speichermedien (CD, DVD, Harddisks) von Vorteil. In einer weiteren bevorzugten Ausführungsform ist das Substrat bewegbar angeordnet, bevorzugt rotierbar um eine zur Substratebene im wesentlichen normale Achse. Dadurch wird die Homogenität des Schichtauftrages verbessert. Insbesondere wenn, wie in einer weiteren bevorzugten Ausführungsform, die Bewegbarkeit des Magnetsystems eine Rotierbarkeit um eine zur Targetebene im wesentlichen normale Achse ist. Gegenüber anderen denkbaren Ausführungsformen hat dies den Vorteil, dass das Magnetsystem äquidistant zur Targetebene bleibt. Weitere Vorteile werden durch einen motorischen Antrieb von Substrat und Magnetsystem erzielt, bevorzugt unabhängig voneinander. Durch gegenläufige Rotation lässt sich wegen der höheren Relativgeschwindigkeit zwischen dem Substrat und dem bevorzugten Abstäubbereich (hervorgerufen durch das rotierende Magnetsystem) eine Homogenisierung des Schichtauftrags auf dem Substrat erzielen.

In einer weiteren bevorzugten Anwendungsform sind Mittel zur Feststellung der Position des Magnetsystems vorhanden. Dies kann durch feste Zuordnung der Antriebsposition erfolgen oder mit einem Sensor erfasst werden wie beispielsweise einem Winkelsensor oder einer Lichtschranke, die über ein Indexloch in einer mitdrehenden Schreibe ein Signal liefert.
Eine besondere Wirkung wird erzielt, wenn das Magnetsystem nicht symmetrisch zu seiner Rotationsachse aufgebaut ist. Der bevorzugte Abstäubbereich bzw. die Verteilung der abgestäubten Partikel auf dem Substrat und das Erosionsprofil am Target lassen sich einstellen., Durch die Rotation wird auch die Homogenität der Abstäubung gewährleistet. Gleichzeitig lässt sich das Magnetsystem kompakter und damit wirtschaftlicher herstellen.

Weitere bevorzugte Ausführungsformen betreffen die Art der Targetteilung. Für ein kreisförmiges Target ist die Ausführung der Segmentierung in Kreissegmente entlang im wesentlich radial verlaufender Fugen vorteilhaft. Die Vorteile betreffen Herstellung (z. B. Herausschneiden aus einteiligen Targets) als auch Zusammenbau. Auch lassen sich Targethalte- und Kühlvorrichtungen von im Stand der Technik bekannten Vorrichtungen kompatibel anwenden. In einer weiteren Ausführungsform werden die Targetsegmente nach dem Bedarf der Ziellegierung zusammengesetzt aus unterschiedlichen Materialien oder Materialmischungen und nach bekannten Verfahren z. B. auf einer Targetrückplatte befestigt, beispielsweise durch Bonden. Alternativ können in einem Volltarget Aussparungen vorgesehen sein, in die Segmente aus weiterem Material eingesetzt werden. Darüberhinaus können diese Segmente ein- oder mehrfach vorhanden sein (z. B. zwei Materialien in vier Segmenten, je alternierend).

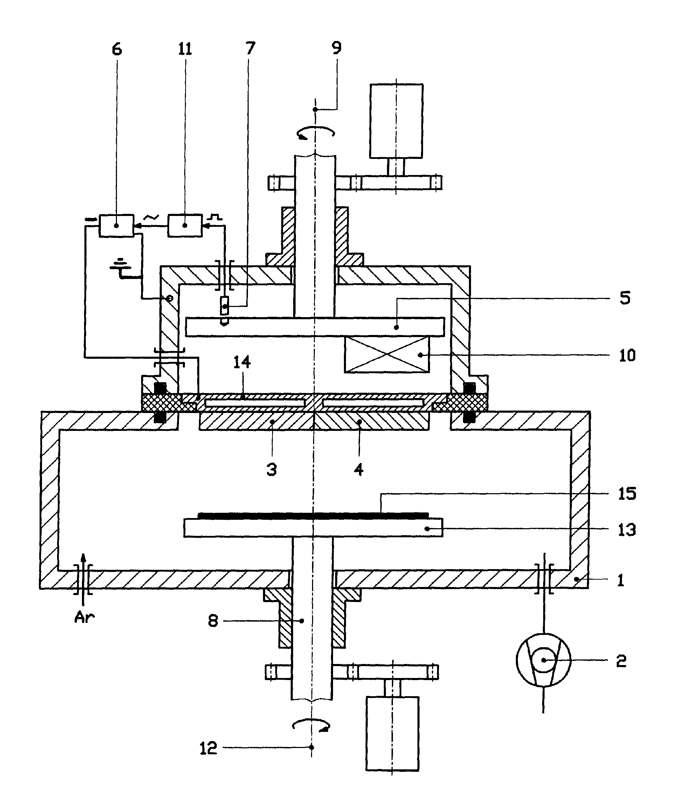

Die beiliegende Figur 1 zeigt ein auf die erfindungswesentlichen Bestandteile reduziertes System zur Beschichtung eines scheibenförmigen, rotierenden Substrats mit einem mehrteiligen Target.

Im folgenden wird die Wirkungsweise der Erfindung anhand der Figur erläutert. Beispielhaft sei ein System zur Beschichtung von Speicherdisks aufgeführt, insbesondere optische Speicherdisks, wie DVDs, und magnetooptische Disks. Die für die Letztgenannten verwendeten Schichten bestehen beispielsweise aus Übergangsmetallen (z. B. Fe, Co) und seltenen Erden (Tb, Gd), die in einer sehr genauen Stöchiometrie aufgebracht werden müssen. Ebenso werden für sogenannte "Phasechange Disks" Legierungen mit genauer Stöchiometrie (z.B. aus In, Ge, Sb, Ag) benötigt.

Eine Vakuumkammer 1 ist über eine Pumpvorrichtung 2 evakuierbar. Auf einer Targetrückplatte 14 sind zwei halbmondförmige Targetsegmente 3 und 4 angebracht. Dahinter, ausserhalb der Vakuumkammer 1 befindet sich das Magnetsystem 5, hier mit einem asymmetrisch zur Targetrotationsachse 9 angeordnetem Magnetkörper 10. Der motorische Antrieb zur Achse 9 ist weggelassen. Am Magnetsystem befindet sich der Sensor 7 zur Positionsermittlung, hier in Form einer Lichtschranke, die einen Impuls an ein Steuermodul 11 liefert. Mit dem vom Steuermodul ausgegebenen Signal wird dann die Stromversorgung 6 moduliert. Bevorzugt wird eine Leistungsoder eine Strommodulation verwendet. Damit wird die Plasmadichte basierend auf der Positionsinformation des Magnetsystems zeitlich moduliert. In der Vakuumkammer 1 befindet sich das Substrat 5 auf einem Substratträger 13. Der motorische Antrieb der Substratrotationsachse 12 ist über die Drehdurchführung 8 realisiert und hier nicht gezeigt.
Dargestellt ist eine koaxiale Anordnung von Target und Substrat 15. Dies erlaubt einen hohen Übertragungsfaktor des gesputterten Materials vom Target auf das Substrat 15.
Weitere Anordnungen lassen sich realisieren zur Erreichung besonderer Effekte wie optimierte Kantenbelegung, z. B. durch Ausbildung eines Winkels zwischen Target und Substratachse, bzw. zur Erhöhung des Durchsatzes der Einsatz eines Planetensystems mit mehreren Substraten.

Im Betrieb wird durch den Sensor 7 die Position des Magnetsystems relativ zur Targetanordnung festgestellt. Diese Information verwertet das Steuermodul 11, das nach den Vorgaben für die zu erzielende Schichtzusammensetzung auf dem Substrat 5 die Stromversorgung 11 entsprechend in ihrer Leistungsabgabe variiert. Durch das Magnetsystem geführt überstreicht damit das Magnetfeld, welches die Elektronenfalle bildet den Bereich der bevorzugten Abstäubung auf den Targethälften 3 und 4. Durch die Rotation des Substrates 5 wird die Belegung homogenisiert sowohl in der Zusammensetzung als auch in der Verteilung.
Durch die Anordnung der Targetrückplatte 14 gegenüber dem Substrat 5 derart, dass die Achsen 9 und 12 zusammenfallen wird eine ideale Substratbelegung mit beiden Materialien erzielt. Bewegliche Blenden im Sputterraum mit der Gefahr von Partikelbildung und Verlust an Sputterrate werden vermieden. Die Schichtdickenverteilung ist für beide Materialien sehr ähnlich, da die gleichen geometrischen Bedingungen (Einfallswinkel, Distanzen) für beide Targetabschnitte gelten. Dadurch ist die konstante Stöchiometrie über das Substrat mit hoher Genauigkeit und Reproduzierbarkeit gewährleistet.
Gegenüber einer handelsüblichen Anlage für magnetooptische Beschichtungen kommt die erfindungsgemässe Vorrichtung mit einem Minimum an zusätzlichen Teilen aus. Im wesentlichen sind Steuermodul 11, das mehrteilige Target und der Sensor erforderlich, als Stromversorgung kann ein handelsübliches Gerät verwendet werden. Targetwechselzeiten und die übrigen Unterhaltsarbeiten sind ebenfalls gleich kurz wie bei Standardanlagen.

## Patentansprüche

1. Verfahren zum Betrieb einer Magnetronsputterquelle mit einem mehrteiligen Target, einem beweglichen Magnetsystem (5) und mindestens einer Stromversorgung (6) zur Plasmaerzeugung, **dadurch gekennzeichnet, dass** die Leistungsabgabe der mindestens einen Stromversorgung (6) im Betrieb variiert wird.

2. Verfahren nach Anspruch 1, **dadurch gekennzeichnet, dass** die Variation der Leistungsabgabe synchronisiert wird mit der Bewegung des Magnetsystems (5), bevorzugt gesteuert und insbesondere periodisch.

3. Verfahren nach Anspruch 1 und 2, **dadurch gekennzeichnet, dass** die Leistungsabgabe synchronisiert wird selektiv mit dem Zusammentreffen von durch das Magnetsystem (5) beeinflussten Abstäubbereichen mit bestimmten Flächen des mehrteiligen Targets.

4. Verfahren nach Anspruch 1 bis 3, **dadurch gekennzeichnet, dass** die Variation der Leistungsabgabe für die Stromversorgung (6) vorgebbar ist, insbesondere durch eine Steuerung (11) wie eine Computersteuerung und vorzugsweise nach vorgebbaren Werten geregelt wird.

5. Verfahren nach Anspruch 1 bis 4, **dadurch gekennzeichnet, dass** Mittel vorgesehen sind zur Feststellung der Lage des Magnetsystems, deren Information zur Synchronisation der Leistungsabgabe verwendet wird.

6. Magnetronsputterquelle zur Beschichtung von Substraten (15) mit einem mehrteiligen Target und einem beweglichen Magnetsystem (5) mit Antrieb, zur Beeinflussung der Abstäubbereiche auf dem Target sowie mindestens einer Stromversorgung (6), **dadurch gekennzeichnet, dass** die Stromversorgung (6) weiter Mittel zur Modulierung der Leistungsabgabe aufweist, wobei weitere Mittel vorgesehen sind zur Synchronisierung mit dem Antrieb des Magnetsystems.

7. Magnetronsputterquelle nach Anspruch 6, **dadurch gekennzeichnet, dass** das mehrteilige Target im wesentlichen kreisförmig ist.

8. Magnetronsputterquelle nach Anspruch 6 und 7, **dadurch gekennzeichnet, dass** das Substrat (15) vor dem Target bewegbar angeordnet ist, bevorzugt rotierbar um eine zur Substratebene im wesentlichen normale Achse (12).

9. Magnetronsputterquelle nach Anspruch 6 bis 8, **dadurch gekennzeichnet, dass** das Magnetsystem (5) rotierbar angeordnet ist, bevorzugt um eine zur Targetebene im wesentlichen normale Achse (9).

10. Magnetronsputterquelle nach Anspruch 8 und 9, **dadurch gekennzeichnet, dass** das Magnetsystem (5) und das Substrat (15) motorisch antreibbar sind, bevorzugt unabhängig voneinander.

11. Magnetronsputterquelle nach Anspruch 6 bis 10, **dadurch gekennzeichnet, dass** mindestens ein Sensor (7) vorhanden ist zur Feststellung der Position des Magnetsystems (5).

12. Magnetronsputterquelle nach Anspruch 9 bis 11, **dadurch gekennzeichnet, dass** das Magnetsystem (5) nicht symmetrisch zu seiner Rotationsachse (9) aufgebaut ist.

13. Magnetronsputterquelle nach Anspruch 6 bis 12, **dadurch gekennzeichnet, dass** die Segmente des Targets (3, 4) als mindestens zwei Kreissegmente mit im wesentlichen radial verlaufenden Fugen ausgeführt sind.

14. Magnetronsputterquelle nach Anspruch 6 bis 13, **dadurch gekennzeichnet, dass** die Targetsegmente (3, 4) aus unterschiedlichen Materialien und/oder Legierungen und/oder Materialmischungen bestehen.

15. Magnetronsputterquelle nach Anspruch 6 bis 14, **dadurch gekennzeichnet, dass** die Leistungsabgabe durch eine einzige Stromversorgung (6) erfolgt.
